(19) Europäisches Patentamt
European Patent Office
Office européen des brevets

(11) **EP 3 136 018 A1**

(12) **DEMANDE DE BREVET EUROPEEN**

(43) Date de publication:
01.03.2017 Bulletin 2017/09

(51) Int Cl.:
*F24J 2/15* (2006.01)   *F24J 2/08* (2006.01)
*H01L 35/00* (2006.01)   *H02S 10/30* (2014.01)
*F24J 2/04* (2006.01)

(21) Numéro de dépôt: **16185628.1**

(22) Date de dépôt: **25.08.2016**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**MA MD**

(30) Priorité: **27.08.2015 FR 1570031**

(71) Demandeur: **COMMISSARIAT A L'ENERGIE
ATOMIQUE ET AUX
ENERGIES ALTERNATIVES
75015 Paris (FR)**

(72) Inventeurs:
• **AIXALA, Luc**
**38120 SAINT-EGREVE (FR)**
• **PEREIRA, Alexandre**
**38950 SAINT-MARTIN-LE-VINOUX (FR)**
• **CAROFF, Tristan**
**38300 BOURGOIN-JALLIEU (FR)**

(74) Mandataire: **Cabinet Laurent & Charras
Le Contemporain
50 Chemin de la Bruyère
69574 Dardilly Cedex (FR)**

(54) **CONCENTRATEUR SOLAIRE A ABSORBEUR TRIDIMENSIONNEL**

(57) Un système de conversion d'énergie solaire comprend :
- un concentrateur solaire (20) muni d'un axe optique (24) et apte à focaliser un rayonnement solaire incident sur un plan focal (22) ;
- un miroir tronconique comprenant une grande base et une petite base, dans lequel la petite base est confondue avec le plan focal (22) du concentrateur solaire (20), le sommet du miroir tronconique (30) est disposé sur l'axe optique (24) du concentrateur solaire (20) et la grande base est disposée entre la petite base et le concentrateur, de sorte que le concentrateur solaire et le miroir tronconique définissent ensemble une surface focale secondaire comprenant une portion inscrite dans la petite base du miroir tronconique et une portion tronconique (30) inscrite dans le volume délimité par le miroir tronconique; et
- un absorbeur solaire (14) inscrivant au moins partiellement la petite base du miroir tronconique ;
L'absorbeur solaire comporte en outre une portion (34) inscrivant l'intersection de la portion tronconique (30) de la surface focale secondaire avec un plan contenant l'axe optique (24) du concentrateur solaire (20).

Fig. 6

EP 3 136 018 A1

**Description**

**DOMAINE DE L'INVENTION**

L'invention a trait aux dispositifs de conversion d'énergie solaire à concentrateur, en particulier dans les domaines photovoltaïque, thermique et thermoélectrique.

**ETAT DE LA TECHNIQUE**

D'une manière générale, un dispositif de conversion d'énergie solaire a pour but de fournir une puissance utile en transformant l'énergie du rayonnement solaire capté. Il comprend à cet effet un absorbeur, c'est-à-dire un élément physique ayant pour fonction de convertir l'énergie électromagnétique solaire incidente en une autre forme d'énergie utile exploitable (e.g. de l'énergie électrique dans le cas d'un module photovoltaïque ou d'un module thermoélectrique, de l'énergie thermique dans le cas d'un chauffe-eau solaire, etc). Or, la puissance utile délivrée par le dispositif dépend de plusieurs facteurs, dont l'efficacité de la conversion de l'absorbeur, la surface de l'absorbeur allouée à la captation du rayonnement solaire (ou « surface de captation ») et la puissance du rayonnement solaire incident sur l'absorbeur. L'efficacité de la conversion dépendant de la technologie employée pour réaliser l'absorbeur, pour une technologie donnée, la puissance utile est donc réglée par la surface allouée à la captation et la puissance du rayonnement.

Notamment, lorsque la surface allouée à la captation du rayonnement solaire est réduite, par exemple pour limiter le coût de l'absorbeur, il est usuel de concentrer la puissance du rayonnement solaire sur l'absorbeur au moyen d'un concentrateur solaire (par exemple un système Cassegrain, un miroir parabolique, une lentille de Fresnel standard ou linéaire, un ensemble de lentilles, etc.). Le concentrateur solaire est un système optique qui focalise le rayonnement solaire sur un plan focal et la surface de captation de l'absorbeur, plane, est confondue avec le plan focal du concentrateur. La focalisation du rayonnement sur la surface de captation de l'absorbeur permet ainsi de compenser la faible dimension de celle-ci.

Toutefois, un dispositif de conversion d'énergie solaire à base de concentrateur solaire est sensible à l'angle d'incidence du rayonnement solaire, et ce d'autant plus que la surface de captation de l'absorbeur est réduite. En effet, il existe toujours un angle d'incidence du rayonnement solaire, défini par rapport à l'axe optique du concentrateur solaire, au-delà duquel la focalisation n'est plus réalisée sur l'absorbeur lui-même.

En outre, l'incidence du soleil varie tout au long de la journée, c'est pourquoi les systèmes de conversion solaire à concentration sont motorisés (e.g. à l'aide d'un traqueur) pour suivre la progression du soleil dans le ciel, afin de garantir une incidence normale du rayonnement solaire. Ce type de système nécessite cependant un suivi du soleil très précis, un léger décalage angulaire (e.g. 0,1°) par rapport au soleil se traduisant directement pour une chute importante des performances du dispositif.

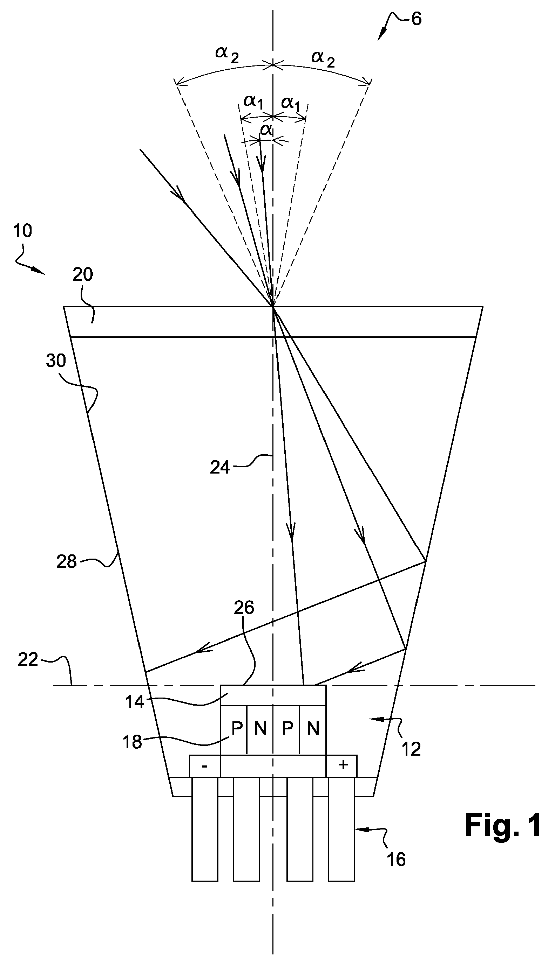

En variante, ou de manière supplémentaire, des dispositifs de conversion solaire embarquent un miroir supplémentaire pour dévier vers l'absorbeur un rayonnement dont l'angle d'incidence est trop important, ce qui permet donc de relâcher la contrainte d'alignement du rayonnement incident. Un tel dispositif de conversion solaire, motorisé ou non, est illustré à la vue schématique en coupe de la figure 1. Le dispositif **10** comprend :

- un convertisseur solaire, par exemple un thermogénérateur **12** constitué d'un absorbeur **14** destiné à être chauffé par le rayonnement solaire (e.g. par les photons infrarouges), et formant donc la source chaude du convertisseur **12,** un radiateur **16** pour évacuer la chaleur et formant donc la source froide du convertisseur **12,** et un ensemble de jonctions PN **18** prises en sandwich entre l'absorbeur **14** et le radiateur **16** pour générer une tension électrique par effet Seebeck en fonction du gradient de température entre l'absorbeur **14** et le radiateur **16** ;
- une optique **20,** par exemple une lentille de Fresnel, apte à focaliser le rayonnement solaire incident sur un plan focal **22** et comprenant un axe optique **24,** usuellement désignée par les termes de « concentrateur » ou d'« optique primaire ». L'absorbeur **14** comporte une face plane **26** comprise dans le plan focal **22** de l'optique **20** afin de recevoir le rayonnement solaire focalisé ; et
- un boitier **28** logeant au moins l'absorbeur, au moins la face interne **30** du boitier **28** comprise entre la lentille **20** et le plan focal **22** formant un miroir tronconique, usuellement désigné par les termes d'«optique secondaire ».

Comme cela est connu, un cône est une surface réglée définie par une demi-droite d'extrémité appelée sommet, et dont un point variable décrit une courbe plane fermée, appelée courbe directrice. Le terme de « tronconique » désigne de manière usuelle une portion du cône ne comprenant pas le sommet de celui-ci et délimitée par deux plans parallèles.

Par exemple, dans le cadre de la figure 1, le cône est un cône de révolution ou pyramidal (et comprenant donc un axe de symétrie passant par le sommet du cône), et les deux plans sont parallèles entre eux, et perpendiculaires à l'axe de symétrie du cône, l'axe de symétrie du cône de révolution ou pyramidale étant confondu avec l'axe optique du concentrateur.

Comme illustré, et en repérant les angles par rapport à l'axe optique **24,** lorsque le rayonnement solaire est incident sur la lentille **20** avec un angle $\alpha$ inférieur à un angle $\alpha_1$ (ci-après « angle limite »), ce rayonnement est alors focalisé par la lentille directement sur la face **26** de l'absorbeur **14.** Lorsque le rayonnement est incident

avec un angle $\alpha$ compris entre l'angle limite $\alpha_1$ et un angle $\alpha_2$, une partie rayonnement est réfléchie par le miroir **30** et redirigée vers l'absorbeur **14,** donc captée. Au-delà de l'angle $\alpha_2$, on observe une chute brutale de l'énergie électrique produite car les rayons n'atteignent plus la surface de captation **26** de l'absorbeur **14.**

La tolérance angulaire des dispositifs à convertisseur et miroir, dont un exemple vient d'être décrit, est généralement de l'ordre de 1° à 3° ($\alpha_2$ compris entre 1° et 3°). La présence du miroir permet donc de relâcher la contrainte sur l'angle d'incidence, et donc par exemple d'utiliser des asservissements plus souples pour le suivi du soleil, et ainsi minimiser le coût du traqueur, qui représente près de 50% du coût total d'un dispositif solaire à concentration.

Toutefois, s'il est observé que le miroir permet de produire de l'énergie pour des angles d'incidence au-delà de l'angle $\alpha_1$ définissant la limite au-delà de laquelle il n'y a plus de focalisation directe du rayonnement sur la surface de captation **26** de l'absorbeur **14,** les inventeurs ont observé que l'énergie produite pour les angles d'incidence compris entre $\alpha_1$ et $\alpha_2$ est cependant inférieure à celle produite pour un angle normal, et est en constante chute au fur et à mesure que l'angle d'incidence augmente. Cette chute est d'ailleurs d'autant plus rapide que le grandissement optique du concentrateur **20** (défini comme égal au rapport entre l'aire de la surface d'incidence du rayonnement solaire, par exemple l'aire de la lentille **20,** et l'aire de la surface de captation **26**) est important.

**EXPOSE DE L'INVENTION**

Le but de la présente invention est de proposer un dispositif de conversion solaire comprenant un concentrateur et un miroir, permettant une production accrue d'énergie pour des angles d'incidence ne permettant pas une focalisation directe du rayonnement solaire sur la portion de plan focal comprise dans le boitier.

A cet effet, l'invention a pour objet un système de conversion d'énergie solaire comprenant :

- un concentrateur solaire muni d'un axe optique et apte à focaliser un rayonnement solaire incident sur un plan focal ;
- un miroir tronconique comprenant une grande base et une petite base, dans lequel la petite base est confondue avec le plan focal de l'optique, le sommet du miroir tronconique est disposé sur l'axe optique du concentrateur et la grande base est disposée entre la petite base et le concentrateur solaire, de sorte que le concentrateur solaire et le miroir tronconique définissent ensemble une surface focale secondaire comprenant une portion inscrite dans la petite base du miroir tronconique et une portion tronconique inscrite dans le volume délimité par le miroir tronconique; et
- un absorbeur solaire inscrivant au moins partiellement la petite base du miroir tronconique.

Selon l'invention, l'absorbeur solaire comporte en outre une portion inscrivant l'intersection de la portion tronconique de la surface focale secondaire avec au moins un plan contenant l'axe optique du concentrateur solaire.

En d'autres termes, en raison de la présence du miroir, la surface optique de focalisation ne se limite pas au seul plan focal de l'optique. Cette surface comprend également une portion définie comme l'image du plan focal du concentrateur par le miroir pour les angles supérieurs à l'angle limite $\alpha_1$. En disposant une partie de l'absorbeur sur cette surface de focalisation « secondaire », on dispose donc d'une focalisation sur l'absorbeur pour le rayonnement solaire qui est incident avec un angle supérieur à l'angle limite $\alpha_1$.

Evidemment, la partie de l'absorbeur disposée sur la surface secondaire de focalisation intercepte une portion du rayonnement initialement destinée à se focaliser sur la partie d'absorbeur disposée sur le plan focal du convertisseur. Cependant le gain de performances pour les angles supérieurs aux angles limites est important, par exemple si le dispositif est fixe, sans tracker. En outre, des essais ont montré que la chute de performance pour les angles d'incidence à l'angle limite $\alpha_1$ est minime à nul. Non seulement, la tolérance angulaire est plus importante, mais en outre il peut même être avantageux d'utiliser des traqueurs moins précis pour produire plus d'énergie.

Selon un mode de réalisation, ladite portion de l'absorbeur solaire est un volume défini par la portion tronconique de la surface focale secondaire.

Selon un mode de réalisation, ladite portion de l'absorbeur est un volume comprenant l'intersection de la portion tronconique de la surface focale secondaire et d'un volume en forme de croix centré sur l'axe optique du concentrateur solaire. Notamment, le miroir tronconique est un miroir tronconique pyramidal comportant des petite et grande bases en forme de parallélogramme, et en ce que le volume en forme de croix comporte deux branches respectivement parallèles aux côtés des grande et petite bases du miroir.

Selon un mode de réalisation, ladite portion de l'absorbeur est un dôme inscrivant totalement la portion tronconique de la surface focale secondaire.

Selon un mode de réalisation, ladite portion de l'absorbeur a une hauteur maximale suivant l'axe optique de l'optique supérieure ou égale à 40% de la plus grande dimension de la petite base du miroir tronconique.

Selon un mode de réalisation, ladite portion de l'absorbeur est creuse.

Selon un mode de réalisation, l'absorbeur est un absorbeur pour thermogénérateur.

Selon un mode de réalisation, l'absorbeur comprend des cellules photovoltaïques ayant chacune une face active positionnée sur la portion tronconique de la surface focale secondaire.

Selon un mode de réalisation, la hauteur de l'absorbeur est déterminée par la relation suivante :

$$H_{opt} = \frac{\frac{L}{2} - tan(\alpha_{max}) * H_L}{cos(\beta)}$$

avec :

L : longueur de l'absorbeur ;
$H_L$ : hauteur du concentrateur solaire ;
$\beta$ : angle du cône focal du miroir tronconique ; et

$$\alpha_{max} = arctan\left(\frac{\frac{L}{2} + \frac{H}{tan(\beta)}}{H_L - H}\right)$$

avec H : hauteur du miroir tronconique.

**BREVE DESCRIPTION DES FIGURES**

L'invention sera mieux comprise à la lecture de la description qui va suivre, donnée uniquement à titre d'exemple, et réalisée en relation avec les dessins annexés, dans lesquels des références identiques désignent des éléments identiques ou équivalents, et dans lesquels :

-   la figure 1 est une vue schématique en coupe d'un convertisseur solaire à concentrateur et optique secondaire de l'état de la technique, les angles représentés ayant été exagérés pour plus de clarté ;
-   la figure 2 est une vue schématique en coupe illustrant la surface de focalisation de la combinaison de l'optique primaire et de l'optique secondaire, y compris pour les rayons incidents ne passant par l'axe focal de l'optique primaire ;
-   les figures 3 et 4 sont des vues schématiques en perspective d'un cône focal secondaire de révolution et d'un cône focal secondaire pyramidal ;
-   les figures 5 à 10 sont des vues schématiques en perspective d'absorbeurs selon différents modes de réalisation selon l'invention ;
-   la figure 11 est une courbe de la hauteur centrale de l'absorbeur en fonction du grandissement de l'optique primaire pour collecter un rayonnement solaire pouvant être désaligné jusqu'à 2° ;
-   la figure 12 illustre des courbes de pertes thermiques pour différents types d'absorbeurs ;
-   la figure 13 illustre la puissance utile générée selon l'invention et selon l'état de la technique en fonction de l'angle du rayonnement incident sur l'optique primaire ;
-   la figure 14 illustre des vues schématiques écorchées d'absorbeurs creux selon l'invention ;
-   la figure 15 est une vue schématique d'un absorbeur formé de modules photovoltaïques selon l'invention ; et
-   la figure 16 est une vue schématique en coupe illustrant la surface de focalisation de la combinaison de l'optique primaire et de l'optique secondaire, y compris pour la détermination de la hauteur optimale de l'absorbeur.

**DESCRIPTION DETAILLEE DE L'INVENTION**

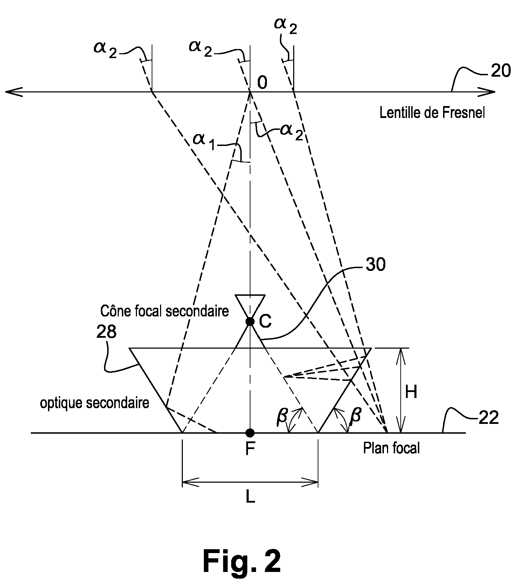

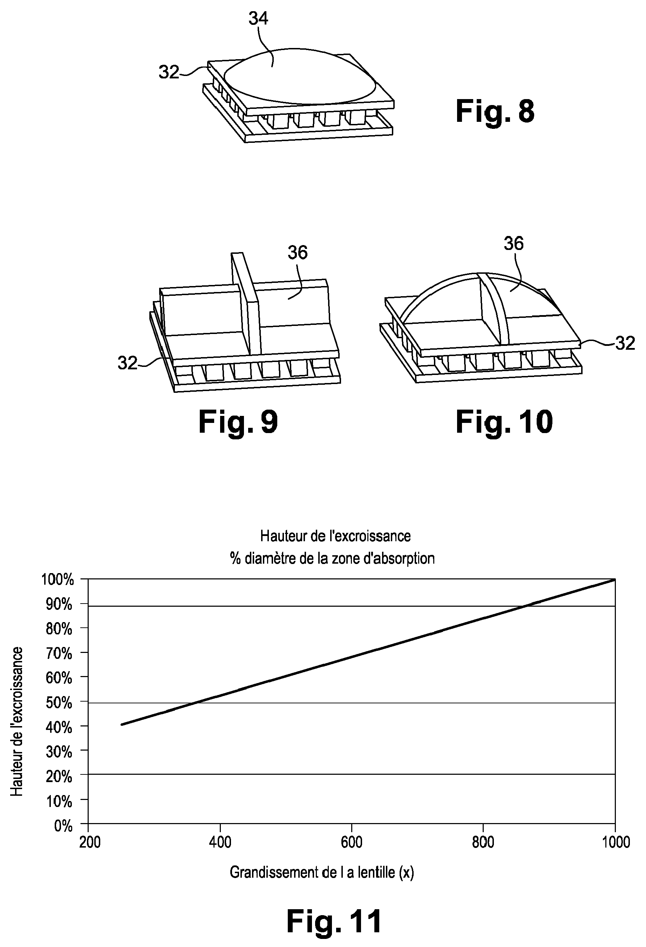

En se référant aux figures 2 à 4, il va être décrit la surface de focalisation formée par la combinaison de l'optique primaire (concentrateur) **20** et de l'optique secondaire (miroir tronconique) **28** de la figure 1.
Comme décrit précédemment, les rayons lumineux perpendiculaires à l'optique primaire **20** convergent vers le point focal F de l'optique, et les rayons parallèles entre eux, et ayant un désalignement α inférieur à l'angle limite $\alpha_1$, convergent en un point du plan focal **22**. Les rayons parallèles entre eux et ayant un désalignement α supérieur à l'angle limite $\alpha_1$ sont quant à eux réfléchis par l'optique secondaire **28** et convergent en un point d'un cône focal secondaire **30**. Ce cône focal secondaire est défini géométriquement à partir de l'optique secondaire (notamment pour un cône de révolution ou pyramidal tronqué, de diamètre ou côté L, d'angle β par rapport au plan des bases et de hauteur H) et de l'optique primaire (notamment la focale F, facteur de grandissement G).

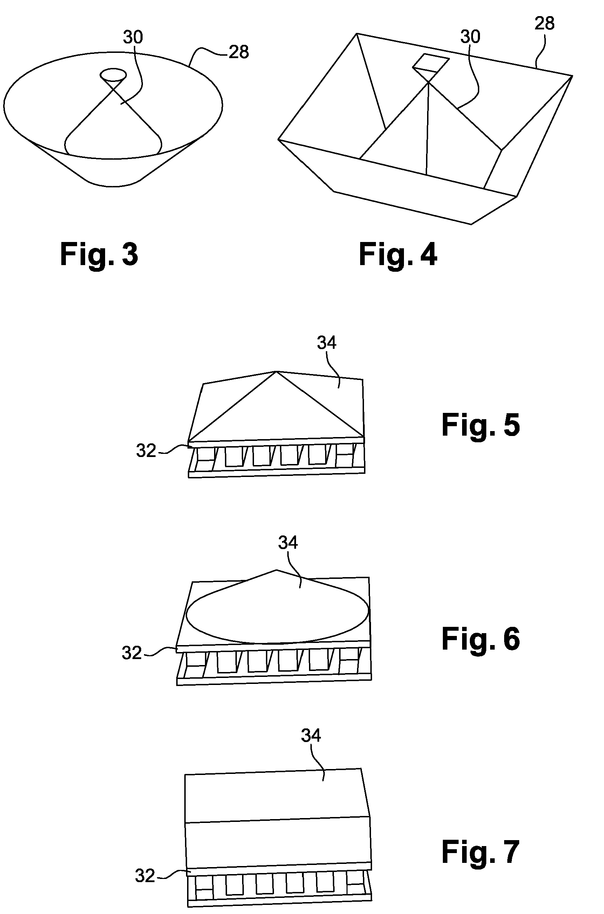

Les figures 3 et 4 illustrent en perspective le cône focal secondaire **30** d'un miroir tronconique de révolution (figure 3) ou pyramidal (figure 4).
L'invention consiste à réaliser un absorbeur de forme complexe non planaire, qui va permettre de collecter l'essentiel des rayons lumineux qui arrivent en dehors de la portion du plan focal **22** occupée par l'absorbeur.
Cet absorbeur est caractérisé par sa forme spécifique, qui comporte une première portion disposée sur le plan focal de l'optique primaire **20**, ainsi qu'une seconde portion faisant saillie hors de ce plan focal pour intercepter le cône focal secondaire **30**. La chaleur générée sur la surface de captation de l'absorbeur est alors transmise par conduction au thermogénérateur.
Dans un premier mode de réalisation, illustré aux figures 5 et 6, l'absorbeur comprend une première portion **32** sur le plan focal de l'optique primaire et une seconde portion **34** ayant la forme de la portion du cône focal secondaire **30** contenue dans le volume défini par le miroir tronconique **28** (ci-après « portion secondaire »), notamment un cône de révolution (figure 5) ou un cône pyramidal (figure 6).
Dans un second mode de réalisation, l'absorbeur a un volume supérieur à celui de la portion secondaire, par exemple le parallélépipède ou la portion de sphère de volume minimal inscrivant la portion secondaire, comme illustrés respectivement aux figures 7 et 8.

Dans un troisième mode de réalisation, l'absorbeur a un volume inférieur à celui de la portion secondaire, tout en inscrivant une portion de celle-ci. Notamment, la seconde portion de l'absorbeur est défini comme l'intersection d'un volume en croix **36** ayant deux branches perpendiculaires, centré sur l'axe optique de l'optique primaire, et donc sur le point focal de celle-ci, avec la portion secondaire, comme illustré à la figures 9 (intersection du volume en croix avec un cône secondaire pyramidale) et à la figure 10 (intersection d'un volume en croix avec un cône secondaire de révolution). Comme on peut le noter à la figure 2, plus la seconde portion de l'absorbeur est élevée plus elle capte de rayons désalignés.

Dans un mode de réalisation, la hauteur de la seconde portion de l'absorbeur est limitée en fonction d'un désalignement maximal souhaité. Ceci permet notamment de limiter la surface de la seconde portion, et donc permet de réduire les pertes thermiques, comme cela sera décrit plus en détail plus loin.

Notamment, la figure 11 illustre la hauteur centrale de la seconde portion de l'absorbeur mesurée sur l'axe de l'optique primaire et à partir du point focal F, pour un angle de désalignement de 2°, en fonction de l'agrandissement de l'optique primaire. En particulier, pour une surface de l'absorbeur de dimension L*L sur le plan focal, et un grandissement de 1000 de l'optique primaire, la hauteur centrale de la seconde partie de l'absorbeur est égale L, ce qui permet de collecter la quasi-totalité des photos incidents avec un angle inférieur ou égal à 2°.

Ainsi par exemple, pour une surface classique d'absorbeur de 1cm*1cm sur le plan focal la hauteur centrale de la seconde partie de l'absorbeur est de l'ordre du cm pour un grandissement de 1000 et de 5-6 mm pour un grandissement de 500.

Si l'absorbeur «tridimensionnel» selon l'invention permet de collecter efficacement l'essentiel des photons traversant l'optique primaire et entrant dans le volume délimité par le miroir tronconique, il présente cependant une surface d'échange avec l'environnement plus élevée que celle des absorbeurs de l'état de la technique. Il en découle une augmentation des pertes thermiques par convection (proportionnelles à h*S, avec h coefficient d'échange thermique et S surface extérieure de l'absorbeur) et par radiation (proportionnelles à $\varepsilon * T^4$, avec $\varepsilon$ l'émissivité du matériau constitutif de l'absorbeur et T la température en surface).

Suivant les caractéristiques de hauteur du dispositif d'absorption tel qu'illustré en relation avec la figure 11, l'augmentation de surface associée aux absorbeurs des figures 5-10 est respectivement de 100% pour les absorbeurs des figures 5, 6 et 10, de 200% pour celui de la figure 8 et de 400% pour les absorbeurs des figures 7 et 9 et pour une concentration (grandissement) x 1000 ; et 30%, 100% et 200% pour une un facteur de grandissement de 250 de l'optique primaire.

Pour une utilisation du système à haute température (> 400°C), par exemple lorsque la résistance thermique du module thermoélectrique (TEG) **18** est élevée, il est donc préférable d'opter pour une architecture type cône ou dôme (figure 5, 6 et 10), afin de minimiser la surface mise en jeu pour l'absorption et également les pertes radiatives (et également un absorbeur à faible émissivité).

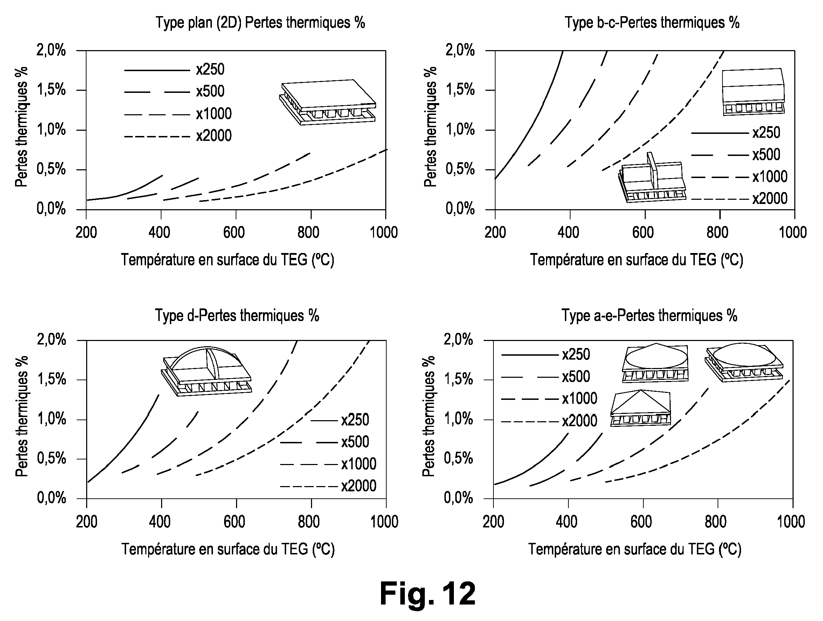

La figure 12 illustre les pertes thermiques générées essentiellement par radiation sur les absorbeurs illustrés ci-dessus pour différents grandissements de l'optique primaire et différentes températures en surface du générateur thermoélectrique (TEG). Les paramètres utilisés pour l'évaluation de ces pertes thermiques sont : un flux solaire incident de 1 Sun (soit 1000 W/m$^2$) et l'émissivité de l'absorbeur 0,1. L'architecture la plus favorable est l'architecture de la figure 6 en cône, ou de la figure 10 en dôme car elles permettent de minimiser la surface d'échange thermique. Dans cette configuration, les pertes thermiques sont globalement inférieures à 2% (soit seulement 1% de plus que l'architecture planaire de l'état de la technique.

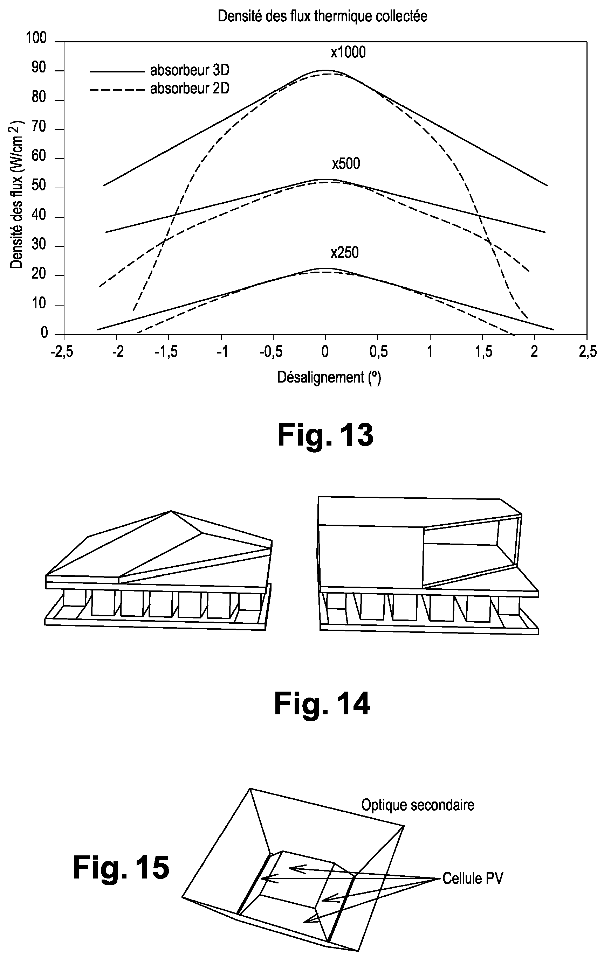

La figure 13 illustre le gain d'un absorbeur 3D pour différents grandissements suivant le désalignement du traqueur.

Avec un désalignement maximal de 2°, pour un grandissement de 1000, l'absorbeur selon l'invention permet de conserver 60% du flux solaire contre 2-3 % pour un absorbeur conventionnel, et pour un grandissement de 500 l'absorbeur selon l'invention permet de conserver 75% du flux solaire contre 40 % pour un absorbeur conventionnel. Avec une architecture 3D optimale (type cône ou dôme) le gain en puissance thermique résultante est donc très important (gain en absorption de 20 à 60% suivant la concentration et le désalignent, pour seulement 1-2 % de pertes thermiques radiatives supplémentaires).

Afin de maximiser la tolérance angulaire des dispositifs de concentration pour le solaire thermoélectrique, l'utilisation d'absorbeurs selon l'invention est préférentiellement mise en oeuvre pour de forts grandissements (entre 200 et 2000).

L'absorbeur selon l'invention est composé d'un matériau thermiquement conducteur (aluminium, cuivre, céramique, etc.), afin de garantir un bon transfert de chaleur jusqu'au module thermoélectrique (TEG), et est recouvert d'une couche de matériau absorbant (revêtement noir ou préférentiellement un absorbeur sélectif permettant d'absorber les photons sur une large gamme du spectre solaire tout en limitant son émissivité (par exemple absorbeur sélectif avec absorption $\alpha$ = 0,9 émissivité $\varepsilon$= 0,1)).

L'absorbeur est par exemple constitué d'un matériau décrit dans l'article de N. Selvakumar et al., « Review of physical vapor deposited (PVD) spectrally selective coatings for mid- and high-temperatire sonar thermal applications », Solar Energy Materials & Solar Cells 98 (2012)

En variante, l'absorbeur peut être creux, tel qu'illustré à la figure 14 afin de limiter sa masse et le coût du système. Une réduction de masse de 80% peut être obtenue par rapport à un absorbeur plein tout en ne perdant que quelques degrés de gradient thermique dans l'absorbeur.

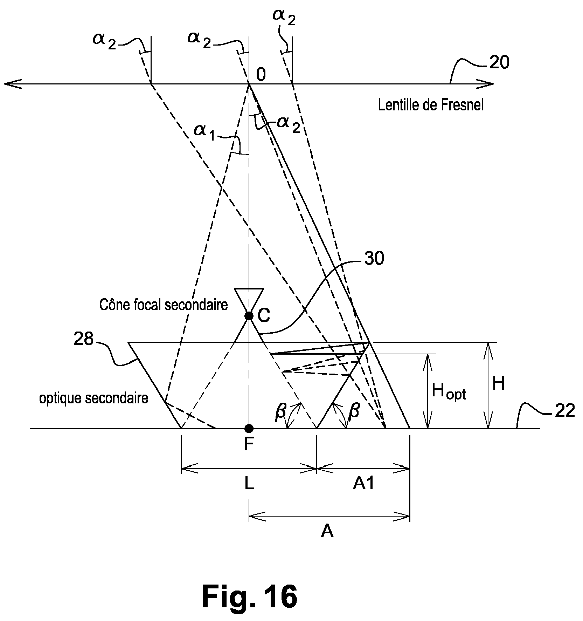

De préférence, une hauteur optimale de l'absorbeur est recherchée de sorte à limiter les pertes thermiques et capter un maximum des rayons lumineux. En référence à la figure 16, cette hauteur optimale est notée $H_{opt}$. Cette hauteur optimale $H_{opt}$ vise à capter l'ensemble des rayons lumineux arrivant sur l'optique secondaire **28**. Il est défini un angle de déviation maximal $\alpha_{max}$ pour lequel un rayon lumineux passant par le centre de l'optique primaire **20** intercepte l'extrémité supérieure de l'optique secondaire **28**. Cet angle de déviation maximal $\alpha_{max}$ peut être obtenu par la relation suivante :

$$\alpha_{max} = arctan\left(\frac{\frac{L}{2} + \frac{H}{\tan(\beta)}}{H_L - H}\right)$$

avec $H_L$ correspondant à la hauteur de l'optique primaire 20.

Une distance A entre le centre de l'optique secondaire **28** et le point atteignant le plan focal **22** pour l'angle de déviation maximal $\alpha_{max}$ peut être obtenu par la relation suivante :

$$A = tan(\alpha_{max}) * H_L$$

Il s'ensuit que la distance $A_1$ entre le bord de l'optique secondaire **28** et le point atteignant le plan focal **22** pour l'angle de déviation maximal $\alpha_{max}$ s'écrit :

$$A_1 = \frac{L}{2} - A$$

Ainsi, la hauteur optimale $H_{opt}$ peut être obtenue selon l'une des relations suivantes :

$$H_{opt} = \frac{A_1}{\cos(\beta)} = \frac{\frac{L}{2} - tan(\alpha_{max}) * H_L}{\cos(\beta)}$$

L'invention a été décrite en relation avec un thermogénérateur (TEG). L'invention s'applique à d'autres types de dispositif de conversion d'énergie solaire, notamment à un module photovoltaïque. Par exemple, en se référant à la figure 15, pour laquelle le miroir tronconique est pyramidal, des cellules photovoltaïques sont disposées sur les flancs du cône secondaire. De manière analogue à l'absorbeur du thermogénérateur, l'absorbeur photovoltaïque (i.e. la structure comprenant des cellules photovoltaïques) peut avoir une hauteur centrale inférieure à la portion secondaire du cône focal, auquel cas une cellule photovoltaïque est également disposée sur le sommet, plan, de la structure.

## Revendications

1. Système de conversion d'énergie solaire comprenant :

   - un concentrateur solaire (20) muni d'un axe optique (24) et apte à focaliser un rayonnement solaire incident sur un plan focal (22) ;
   - un miroir tronconique comprenant une grande base et une petite base, dans lequel la petite base est confondue avec le plan focal (22) du concentrateur solaire (20), le sommet du miroir tronconique (30) est disposé sur l'axe optique (24) du concentrateur solaire (20) et la grande base est disposée entre la petite base et le concentrateur, de sorte que le concentrateur solaire et le miroir tronconique définissent ensemble une surface focale secondaire comprenant une portion inscrite dans la petite base du miroir tronconique et une portion tronconique (30) inscrite dans le volume délimité par le miroir tronconique; et
   - un absorbeur solaire (14) inscrivant au moins partiellement la petite base du miroir tronconique ;

   *caractérisé* **en ce que** l'absorbeur solaire comporte en outre une portion inscrivant l'intersection de la portion tronconique (30) de la surface focale secondaire avec un plan contenant l'axe optique (24) du concentrateur solaire (20).

2. Système de conversion d'énergie solaire selon la revendication 1, *caractérisé* **en ce que** ladite portion de l'absorbeur solaire est un volume défini par la portion tronconique de la surface focale secondaire.

3. Système de conversion d'énergie solaire selon la revendication 1, *caractérisé* **en ce que** ladite portion de l'absorbeur est un volume comprenant l'intersection de la portion tronconique de la surface focale secondaire et d'un volume en forme de croix centré sur l'axe optique du concentrateur solaire.

4. Système de conversion d'énergie solaire selon la revendication 3, *caractérisé* **en ce que** le miroir tronconique est un miroir tronconique pyramidal comportant des petite et grande bases en forme de parallélogramme, et **en ce que** le volume en forme de croix comporte deux branches respectivement parallèles aux côtés des grande et petite bases du miroir.

5. Système de conversion d'énergie solaire selon la revendication 1, ***caractérisé* en ce que** ladite portion de l'absorbeur est un dôme inscrivant totalement la portion tronconique de la surface focale secondaire.

6. Système de conversion d'énergie solaire selon l'une quelconque des revendications précédentes, ***caractérisé* en ce que** ladite portion de l'absorbeur a une hauteur maximal suivant l'axe optique de l'optique supérieure ou égale à 40% de la plus grande dimension de la petite base du miroir tronconique.

7. Système de conversion d'énergie solaire selon l'une quelconque des revendications précédentes, ***caractérisé* en ce que** ladite portion de l'absorbeur est creuse.

8. Système de conversion d'énergie solaire selon l'une quelconque des revendications précédentes, ***caractérisé* en ce que** l'absorbeur est un absorbeur pour thermogénérateur.

9. Système de conversion d'énergie solaire selon l'une quelconque des revendications précédentes, ***caractérisé* en ce que** l'absorbeur comprend des cellules photovoltaïques ayant chacune une face active positionnée sur la portion tronconique de la surface focale secondaire.

10. Système de conversion d'énergie solaire selon l'une quelconque des revendications précédentes, ***caractérisé* en ce que** la hauteur de l'absorbeur ($H_{opt}$) est déterminée par la relation suivante :

$$H_{opt} = \frac{\frac{L}{2} - tan(\alpha_{max}) * H_L}{\cos(\beta)}$$

avec :

> $L$ : longueur de l'absorbeur ;
> $H_L$ : hauteur du concentrateur solaire (20) ;
> $\beta$ : angle du cône focal du miroir tronconique ; et

$$\alpha_{max} = arctan\left(\frac{\frac{L}{2} + \frac{H}{\tan(\beta)}}{H_L - H}\right)$$

avec $H$ : hauteur du miroir tronconique.

Fig. 1

$\alpha_2$ $\alpha_2$ $\alpha_2$

0

20

Lentille de Fresnel

$\alpha_1$ $\alpha_2$

$\alpha_2$

30

Cône focal secondaire

C

28

optique secondaire

H

$\beta$ $\beta$

22

F

Plan focal

L

**Fig. 2**

**Fig. 3**

**Fig. 4**

**Fig. 5**

**Fig. 6**

**Fig. 7**

34

32

**Fig. 8**

36

36

32

32

**Fig. 9**    **Fig. 10**

Hauteur de l'excroissance
% diamètre de la zone d'absorption

**Fig. 11**

Fig. 12

Densité des flux thermique collectée

**Fig. 13**

**Fig. 14**

**Fig. 15**

Optique secondaire

Cellule PV

**Fig. 16**

**Europäisches Patentamt**

**European Patent Office**

**Office européen des brevets**

## RAPPORT DE RECHERCHE EUROPEENNE

Numéro de la demande

EP 16 18 5628

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2014/230808 A1 (JOHNSON NELDON P [US]) 21 août 2014 (2014-08-21) | 1,6-8,10 | INV. F24J2/15 |
| Y | * alinéa [0019] - alinéa [0023]; figure 1 * | 2,5,9 | F24J2/08 H01L35/00 |
| | ----- | | H02S10/30 |
| Y | DATABASE WPI Week 198701 7 mai 1986 (1986-05-07) Thomson Scientific, London, GB; AN 1987-005551 XP002759878, & SU 1 229 526 A1 (ODESS ENG CONS INST) 7 mai 1986 (1986-05-07) * abrégé * | 2,5 | F24J2/04 |
| | ----- | | |
| Y | US 2007/246095 A1 (SCHAEFER GUENTER [US]) 25 octobre 2007 (2007-10-25) * alinéa [0027] - alinéa [0028]; figures * | 9 | |
| | ----- | | |
| X | US 2012/305077 A1 (ARAB RA ED [CA] ET AL) 6 décembre 2012 (2012-12-06) * alinéas [0038], [0039]; figure 3 * * alinéa [0056] - alinéa [0059]; figure 8 * | 1,6,9,10 | DOMAINES TECHNIQUES RECHERCHES (IPC) F24J H01L H02S |
| | ----- | | |
| A | US 4 612 914 A (DOGEY KENT A [US]) 23 septembre 1986 (1986-09-23) * page 1, ligne 64 - ligne 68; figures * | 1-9 | |
| | ----- | | |

Le présent rapport a été établi pour toutes les revendications

| Lieu de la recherche | Date d'achèvement de la recherche | Examinateur |
|---|---|---|
| La Haye | 10 janvier 2017 | Mootz, Frank |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 16 18 5628

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-01-2017

| Document brevet cité au rapport de recherche | Date de publication | Membre(s) de la famille de brevet(s) | Date de publication |
|---|---|---|---|
| US 2014230808 A1 | 21-08-2014 | AUCUN | |
| SU 1229526 A1 | 07-05-1986 | AUCUN | |
| US 2007246095 A1 | 25-10-2007 | AUCUN | |
| US 2012305077 A1 | 06-12-2012 | CA 2783457 A1 | 18-08-2011 |
| | | CN 102893415 A | 23-01-2013 |
| | | EP 2534703 A1 | 19-12-2012 |
| | | JP 2013520785 A | 06-06-2013 |
| | | US 2012305077 A1 | 06-12-2012 |
| | | WO 2011097704 A1 | 18-08-2011 |
| US 4612914 A | 23-09-1986 | AUCUN | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **N. SELVAKUMA et al.** Review of physical vapor deposited (PVD) spectrally selective coatings for mid- and high-temperatire sonar thermal applications. *Solar Energy Materials & Solar Cells,* 2012, 98